Europäisches Patentamt

European Patent Office

Office européen des brevets

(11) Publication number: **0 544 264 A1**

## EUROPEAN PATENT APPLICATION

(21) Application number: **92120111.7**

(51) Int. Cl.⁵: **G03F 7/023**

(22) Date of filing: **25.11.92**

(30) Priority: **27.11.91 JP 311241/91**

(43) Date of publication of application:
**02.06.93 Bulletin 93/22**

(84) Designated Contracting States:
**DE GB NL**

(71) Applicant: **FUJI PHOTO FILM CO., LTD.**
**No. 210, Nakanuma Minami-Ashigara-shi**
**Kanagawa-ken(JP)**

(72) Inventor: **Mizutani, Kazuyoshi, c/o Fuji Photo**
**Film Co. Ltd.**
**No. 4000, Kawashiri, Yoshida-cho**
**Haibara-gun, Shizuoka-ken(JP)**
Inventor: **Watanabe, Takuo, c/o Fuji Photo**
**Film Co. Ltd.**
**No. 4000, Kawashiri, Yoshida-cho**
**Haibara-gun, Shizuoka-ken(JP)**
Inventor: **Nagashima, Akira, c/o Fuji Photo**
**Film Co. Ltd.**
**No. 4000, Kawashiri, Yoshida-cho**
**Haibara-gun, Shizuoka-ken(JP)**

(74) Representative: **Patentanwälte Grünecker,**
**Kinkeldey, Stockmair & Partner**
**Maximilianstrasse 58**
**W-8000 München 22 (DE)**

(54) **Light-sensitive composition.**

(57) A light-sensitive composition comprises a water-insoluble and alkaline aqueous solution-soluble polymeric compound comprising structural units represented by the following general formulas (I) and/or (II) and a positive-working light-sensitive compound:

$$-[CH_2\text{-}CH(CO\text{-}X^1\text{-}R^1\text{-}SO_2NH\text{-}R^2)]- \quad (I)$$

$$-[CH_2\text{-}CH(CO\text{-}X^2\text{-}R^3\text{-}NHSO_2\text{-}R^4)]- \quad (II)$$

wherein $X^1$ and $X^2$ each represents -O- or -NR⁵ -; $R^1$ and $R^3$ each represents a substituted or unsubstituted alkylene, cycloalkylene, arylene or aralkylene group; $R^2$ represents a hydrogen atom or a substituted or unsubstituted alkyl, cycloalkyl, aryl or aralkyl group; $R^4$ represents a substituted or unsubstituted alkyl, cycloalkyl, aryl or aralkyl group; and $R^5$ represents a hydrogen atom or a substituted or unsubstituted alkyl, cycloalkyl, aryl or aralkyl group. The light-sensitive composition has good solubility in a coating solvent and coating properties and the imagewise exposed area thereof has good developability with respect to an aqueous alkaline developer. Further, the resulting relief images has excellent wear resistance, good adhesion to the substrate, excellent resistance to defects such as those formed through scratching and/or rubbing and can provide a large number of copies when used as a lithographic printing plate.

EP 0 544 264 A1

## BACKGROUND OF THE INVENTION

The present invention relates to a light-sensitive composition suitable for use in a lithographic printing plate, an IC circuit or a photomask and more specifically to a light-sensitive composition comprising a positive-working light-sensitive compound and a polymeric compound excellent in resistance to defects such as scratch marks, wear resistance, resistance to chemicals and solubility in a coating solvent.

A light-sensitive composition comprising an o-naphthoquinonediazide compound and a novolak phenol resin is one of highly excellent light-sensitive compositions and has been industrially used in preparation of a lithographic printing plate and as a photoresist.

However, the novolak phenol resin used as a principal ingredient thereof suffers from a variety of problems such that it has a low adhesion to a substrate by nature, that a film formed therefrom is brittle, that it has poor coating properties and low wear resistance, that the resulting lithographic printing plate has low printing durability and that it has low resistance to chemicals and low resistance to defects formed due to, for instance, scratching and rubbing.

There have been investigated various polymeric compounds as binders to solve these problems. For instance, Japanese Patent Publication for Opposition Purpose (hereinafter referred to as "J.P. KOKOKU") No. Sho 52-41050 proposes the use of polyhydroxystyrene or hydroxystyrene copolymers. The use of these polymers ensures the improvement of properties of the resulting film, but these polymers do not permit sufficient improvement of the wear resistance and resistance to chemicals of the resulting films. Moreover, Japanese Unexamined Patent Publication (hereinafter referred to as "J.P. KOKAI") No. Sho 51-34711 proposes the use of a polymeric compound carrying repeating units derived from acrylic acid derivatives in the molecular structure thereof, as a binder. However, the polymer still suffers from the problems such that the polymer makes the range of appropriate conditions for development of the resulting light-sensitive composition narrow and that it has insufficient wear resistance.

The polymeric compounds carrying sulfonamido groups as disclosed in J.P. KOKAI No. Hei 2-866 can be used as binders having excellent resistance to chemicals, wear resistance and resistance to defects, but all of the compounds disclosed in Examples of this patent are insufficiently soluble in methyl ethyl ketone which is employed as one of the most preferred coating solvents and the use of these compounds as binders for novolak resins does not ensure sufficient printing durability since they are less compatible with the novolak resins.

Moreover, the polymers make the range of appropriate conditions for development of the resulting light-sensitive composition narrow since a large amount of the unreacted monomer having a sulfonamido group remains in the reaction solution after the synthesis of the polymer.

## SUMMARY OF THE INVENTION

Accordingly, an object of the present invention is to provide a light-sensitive composition which can provide a lithographic printing plate having high printing durability using a polymeric compound serving as a binder which is excellent in wear resistance and can be developed with an aqueous alkaline developer.

Another object of the present invention is to provide a light-sensitive composition which can provide a lithographic printing plate having excellent resistance to chemicals and resistance to defects formed due to, for instance, rubbing and/or scratching.

A further object of the present invention is to provide a light-sensitive composition which makes the range of appropriate conditions for development wide.

The inventors of this invention have investigated polymeric compounds carrying sulfonamido groups to accomplish the foregoing objects, have found that these object can effectively be achieved through the use of a polymeric compound comprising structural units represented by the following general formula (I) or (II) as a binder and thus have completed the present invention.

According to the present invention, there is provided a light-sensitive composition which comprises a water-insoluble and alkaline aqueous solution-soluble polymeric compound comprising structural units represented by the following general formulas (I) and/or (II) and a positive-working light-sensitive compound:

$$-[CH_2-CH(CO-X^1-R^1-SO_2NH-R^2)]- \quad (I)$$

$$-[CH_2-CH(CO-X^2-R^3-NHSO_2-R^4)]- \quad (II)$$

wherein $X^1$ and $X^2$ each represents -O- or -NR$^5$ -; $R^1$ and $R^3$ each represents a substituted or unsubstituted alkylene, cycloalkylene, arylene or aralkylene group; $R^2$ represents a hydrogen atom or a substituted or

EP 0 544 264 A1

unsubstituted alkyl, cycloalkyl, aryl or aralkyl group; $R^4$ represents a substituted or unsubstituted alkyl, cycloalkyl, aryl or aralkyl group; and $R^5$ represents a hydrogen atom or a substituted or unsubstituted alkyl, cycloalkyl, aryl or aralkyl group.

DESCRIPTION OF THE PREFERRED EMBODIMENTS

The light-sensitive composition of the present invention will be explained in more detail below.

The polymeric compounds used in the present invention can be prepared by polymerizing monomers represented by the following general formulas (III) and/or (IV) in an appropriate solvent in the presence of a known polymerization initiator:

$$CH_2 = CH(CO\text{-}X^1\text{-}R^1\text{-}SO_2NH\text{-}R^2) \quad (III)$$

$$CH_2 = CH(CO\text{-}X^2\text{-}R^3\text{-}NH\text{-}SO_2\text{-}R^4) \quad (IV)$$

Wherein $X^1$ and $X^2$ each represents -O- or -$NR^5$ -; $R^1$ and $R^3$ each represents a substituted or unsubstituted $C_1$-$C_{12}$ alkylene, $C_6$-$C_{12}$ cycloalkylene, $C_6$-$C_{12}$ arylene or $C_7$-$C_{14}$ aralkylene group; $R^2$ represents a hydrogen atom or a substituted or unsubstituted $C_1$-$C_{12}$ alkyl, $C_6$-$C_{12}$ cycloalkyl, $C_6$-$C_{12}$ aryl or $C_7$-$C_{14}$ aralkyl group; $R^4$ represents a substituted or unsubstituted $C_1$-$C_{12}$ alkyl, $C_6$-$C_{12}$ cycloalkyl, $C_6$-$C_{12}$ aryl or $C_7$-$C_{14}$ aralkyl group; and $R^5$ represents a hydrogen atom or a substituted or unsubstituted $C_1$-$C_{12}$ alkyl, $C_6$-$C_{12}$ cycloalkyl, $C_6$-$C_{12}$ aryl or $C_7$-$C_{14}$ aralkyl group.

Among these low molecular weight compounds represented by Formula (III) or (IV), particularly preferred are, for instance, those in which $R^1$ and $R^3$ each represents a $C_2$-$C_6$ alkylene group, a $C_6$-$C_{12}$ cycloalkylene group or a substituted or unsubstituted phenylene or naphthylene group; $R^2$ represents a hydrogen atom or a $C_1$-$C_6$ alkyl group, a $C_6$-$C_{12}$ cycloalkyl group or a substituted or unsubstituted phenyl or naphthyl group; $R^4$ represents a $C_1$-$C_6$ alkyl group, a $C_6$-$C_{12}$ cycloalkyl group or a substituted or unsubstituted phenyl or naphthyl group; and $R^5$ represents a hydrogen atom.

Specific examples of these low molecular weight compounds include:

acrylamides such as N-(o-aminosulfonylphenyl)acrylamide, N-(m-aminosulfonylphenyl)acrylamide, N-(p-aminosulfonylphenyl) acrylamide, N-(o-methylaminosulfonylphenyl)acrylamide, N-(m-methylaminosulfonylphenyl)acrylamide, N-(p-meth ylaminosulfonylphenyl)acrylamide, N-(o-ethylaminosulfonylphenyl) acrylamide, N-(m-ethylaminosulfonylphenyl)acrylamide, N-(p-ethylaminosulfonylphenyl)acrylamide, N-(o-n-pro pylaminosulfonylphenyl)acrylamide, N-(m-n-propyl aminosulfonylphenyl)acrylamide, N-(p-n-propyl aminosulfonylphenyl)acrylamide, N-(o-i-propylaminosulfonylphenyl) acrylamide, N-(m-i-propylaminosulfonylphenyl)-acrylamide, N-(p-i-propylaminosulfonylphenyl)acrylamide, N-(o-n-butyl aminosulfonylphenyl)acrylamide, N-(m-n-butylamino sulfonylphenyl)acrylamide, N-(p-n-butylaminosulfonylphenyl) acrylamide, N-(o-i-butylaminosulfonylphenyl)acrylamide, N-(m-i-butylaminosulfonylphenyl)acrylamide, N-(p-i-but ylaminosulfonylphenyl)acrylamide, N-(o-sec-butyl aminosulfonylphenyl)acrylamide, N-(m-sec-butylam inosulfonylphenyl)acrylamide, N-(p-sec-butylaminosulfonylphenyl) acrylamide, N-(o-t-butylaminosulfonylphenyl)-acrylamide, N-(m-t-butylaminosulfonylphenyl)acrylamide, N-(p-t-but ylaminosulfonylphenyl)acrylamide, N-(o-phenyl aminosulfonylphenyl)acrylamide, N-(m-phenylaminosulfonylphenyl) acrylamide, N-(p-phenylaminosulfonylphenyl)acrylamide, N-(o-($\alpha$ -naphthylaminosulfonyl)phenyl)acrylamide, N-(m-($\alpha$-naph-thylaminosulfonyl)phenyl)acrylamide, N-(p-($\alpha$-naphthylaminosulfonyl)phenyl)acrylamide, N-(o-($\beta$-naph-thylaminosulfonyl)phenyl)acrylamide, N-(m-($\beta$-naphthylaminosulfonyl)phenyl)acrylamide, N-(p-($\beta$-naph-thylaminosulfonyl)phenyl)acrylamide, N-(1-(3-aminosulfonyl) naphthyl)acrylamide, N-(1-(3-methylaminosulfonyl)naphthyl) acrylamide, N-(1-(3-ethylaminosulfonyl)naphthyl)acrylamide, N-(o-methylsulfonylaminophenyl)acrylamide, N-(m-methylsulfonylaminophenyl)acrylamide, N-(p-methyls ulfonylaminophenyl)acrylamide, N-(o-ethylsulfonylaminophenyl) acrylamide, N-(m-ethylsulfonylaminophenyl)-acrylamide, N-(p-ethylsulfonylaminophenyl)acrylamide, N-(o-phenyl sulfonylaminophenyl)acrylamide, N-(m-phenylsulfonylaminophenyl) acrylamide, N-(p-phenylsulfonylaminophenyl)acrylamide, N-(o-(p-methylphenylsulfonylamino)phenyl)acrylamide, N-(m-(p-methylphenylsulfonylamino)phenyl)acrylamide, N-(p-(p-methylphenylsulfonylamino)phenyl)acrylamide, N-(p-($\alpha$-naphthylsulfonylamino)phenyl)acrylamide, N-(p-($\beta$-naphthyl-sulfonylamino)phenyl)acrylamide, N-(2-m ethylsulfonylaminoethyl)acrylamide, N-(2-ethyl sulfonylaminoethyl)acrylamide, N-(2-phenylsulfonylaminoethyl) acrylamide, N-(2-p-methylphenylsul-fonylaminoethyl)acrylamide, N-(2-$\alpha$-naphthylsulfonylaminoethyl)acrylamide and N-(2-$\beta$ naphthylsul-fonylaminoethyl)acrylamide; and

acrylates such as o-aminosulfonylphenyl acrylate, m-aminosulfonylphenyl acrylate, p-aminosulfonylphenyl acrylate, o-methylaminosulfonylphenyl acrylate, m-methylaminosulfonylphenyl acrylate, p-

3

methylaminosulfonylphenyl acrylate, o-ethylaminosulfonylphenyl acrylate, m-ethylaminosulfonylphenyl acrylate, p-ethylaminosulfonylphenyl acrylate, o-n-propylaminosulfonylphenyl acrylate, m-n-propyl aminosulfonylphenyl acrylate, p-n-propylaminosulfonylphenyl acrylate, o-i-propylaminosulfonylphenyl acrylate, m-i-propylaminosulfonylphenyl acrylate, o-n-butylamino sulfonylphenyl acrylate, m-n-butylaminosulfonylphenyl acrylate, p-n-butylaminosulfonylphenyl acrylate, m-i-butylaminosulfonylphenylacrylate, p-i-butylaminosulfonylphenyl acrylate, m-sec-butylaminosulfonylphenyl acrylate, p-sec-butylaminosulfonylphenyl acrylate, m-t-butylaminosulfonylphenyl acrylate, p-t-butylaminosulfonylphenyl acrylate, o-phenylaminosulfonylphenyl acrylate, m-phenylaminosulfonylphenyl acrylate, p-phenylaminosulfonylphenyl acrylate, m-($\alpha$-naphthylaminosulfonyl)phenyl acrylate, p-($\alpha$-n aphthylaminosulfonyl)phenyl acrylate, m-($\beta$-nap hthylaminosulfonyl)phenyl acrylate, p-($\beta$-nap hthylaminosulfonyl)phenyl acrylate, 1-(3-aminosulfonyl)naphthyl acrylate, 1-(3-methylaminosulfonyl)naphthyl acrylate, 1-(3-ethylaminosulfonyl)naphthyl acrylate, o-methyl sulfonylaminophenyl acrylate, m-methylsulfonylaminophenyl acrylate, p-methylsulfonylaminophenyl acrylate, o-ethylsulfonylaminophenyl acrylate, m-ethylsulfonylaminophenyl acrylate, p-ethylsulfonylaminophenyl acrylate, o-phenylsulfonylaminophenyl acrylate, m-phenylsulfonylaminophenyl acrylate, p-phenylsulfonylaminophenyl acrylate, o-(p-methylphenylsulfonylamino)phenyl acrylate, m-(p-methylphenylsulfonylamino)phenyl acrylate, p-(p-methylphenylsulfonylamino)phenyl acrylate, p-($\alpha$-naphthylsulfonylamino)phenyl acrylate, p-($\beta$-n aphthylsulfonylamino)phenyl acrylate, 2-methylsulfonylaminoethyl acrylate, 2-ethylsulfonylaminoethyl acrylate, 2-phenylsulfonylaminoethyl acrylate, 2-p-methyl phenylsulfonylaminoethyl acrylate, 2-$\alpha$-naphthyl sulfonylaminoethyl acrylate and 2-$\beta$-naphthylsulfonylaminoethyl acrylate.

The polymeric compounds having the structural units represented by Formulas (I) and/or (II) which are preferably used in the invention may be homopolymers of monomers represented by Formula (III) or (IV) or copolymers of at least two monomers selected from those represented by Formulas (III) and/or (IV), but preferably copolymers of at least one monomer selected from those represented by Formulas (III) and/or (IV) with at least one compound having at least one polymerizable unsaturated bond and free of sulfonamido group.

The compounds having at least one polymerizable unsaturated bond and free of sulfonamido group are, for instance, polymerizable unsaturated bond-containing compounds selected from the group consisting of, for instance, (meth) acrylic acid, (meth)acrylates, (meth)acrylamides, allyl compounds, vinyl ethers, vinyl esters, styrenes and crotonates.

Specific examples thereof include:

acrylates such as alkyl (preferably having 1 to 10 carbon atoms) acrylates (e.g., methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropylacrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate and tetrahydrofurfuryl acrylate), aryl acrylates (e.g., phenyl acrylate), butoxyethyl acrylate, methoxydiethylene glycol acrylate, ethoxydiethylene glycol acrylate, methoxytriethylene glycol acrylate, ethoxytriethylene glycol acrylate, methoxypolyethylene glycol acrylate $[CH_2 = CH(CO_2\text{-}(CH_2 CH_2 O)_n\text{-}CH_2 ), n \geq 4]$, 2-hydroxyethyl acrylate and 2-acryloyloxyethyl acid phosphate);

methacrylates such as alkyl (preferably having 1 to 10 carbon atoms) methacrylates (e.g., methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate and tetrahydrofurfuryl methacrylate), aryl methacrylates (e.g., phenyl methacrylate, cresyl methacrylate and naphthyl methacrylate), butoxyethyl methacrylate, methoxydiethylene glycol methacrylate, ethoxydiethylene glycol methacrylate, methoxytriethylene glycol methacrylate, ethoxytriethylene glycol methacrylate, methoxypolyethylene glycol methacrylate $[(CH_2 = C(CH_3)(CO_2\text{-}(CH_2 CH_2 O)_n \text{-}CH_3), n \geq 4]$, 2-hydroxyethyl methacrylate and 2-methacryloyloxyethyl acid phosphate);

acrylamides such as acrylamide, N-alkylacrylamide (the alkyl group may be one having 1 to 10 carbon atoms such as methyl, ethyl, propyl, butyl, t-butyl, heptyl, octyl, cyclohexyl, benzyl or hydroxyethyl), N-arylacrylamide (the aryl group may be, for instance, a phenyl, tolyl, nitrophenyl, naphthyl or hydroxyphenyl group), N,N-dialkylacrylamide (the alkyl group may be one having 1 to 10 carbon atoms such as methyl, ethyl, butyl, isobutyl, ethylhexyl or cyclohexyl), N,N-diarylacrylamide (the aryl group may be, for instance, phenyl group), N-methyl-N-phenylacrylamide, N-hydroxyethyl-N-methylacrylamide and N-2-acetamidoethyl-N-acetylacrylamide;

methacrylamides such as methacrylamide, N-alkylmethacrylamide (the alkyl group may be one having 1 to 10 carbon atoms such as methyl, ethyl, t-butyl, ethylhexyl, hydroxyethyl or cyclohexyl), N-arylmethacrylamide (the aryl group may be, for instance, phenyl group), N,N-dialkylmethacrylamide (the alkyl group may be, for instance, ethyl, propyl or butyl group), N,N-diarylmethacrylamide (the aryl group may be, for instance, phenyl group), N-hydroxyethyl-N-methylmethacrylamide, N-methyl-N-phenylmethacrylamide and N-ethyl-N-phenylmethacrylamide;

allyl compounds such as allyl esters (for instance, allyl acetate, allyl caproate, allyl caprylate, allyl laurate, allyl palmitate, allyl stearate, allyl benzoate, allyl acetoacetate and allyl lactate) and allyl oxyethanol;

vinyl ethers such as alkyl vinyl ether (for instance, hexyl vinyl ether, octyl vinyl ether, decyl vinyl ether, ethylhexyl vinyl ether, methoxyethyl vinyl ether, ethoxyethyl vinyl ether, chloroethyl vinyl ether, 1-methyl-2,2-dimethylpropyl vinyl ether, 2-ethylbutyl vinyl ether, hydroxyethyl vinyl ether, diethylene glycol vinyl ether, dimethylaminoethyl vinyl ether, diethylaminoethyl vinyl ether, butylaminoethyl vinyl ether, benzyl vinyl ether and tetrahydrofurfuryl vinyl ether), vinyl aryl ethers (for instance, vinyl phenyl ether, vinyl tolyl ether, vinyl chlorophenyl ether, vinyl 2,4-dichlorophenyl ether, vinyl naphthyl ether and vinyl anthranyl ether;

vinyl esters such as vinyl butyrate, vinyl isobutyrate, vinyl trimethylacetate, vinyl diethylacetate, vinyl valerate, vinyl caproate, vinyl chloroacetate, vinyl dichloroacetate, vinyl methoxyacetate, vinyl butoxyacetate, vinyl phenylacetate, vinyl acetoacetate, vinyl lactate, vinyl $\beta$-phenylbutyrate, vinyl cyclohexylcarboxylate, vinyl benzoate, vinyl salicylate, vinyl chlorobenzoate, vinyl tetrachlorobenzoate and vinyl naphthoate;

styrenes such as styrene, alkylstyrene (for instance, methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene and acetoxymethylstyrene), alkoxystyrene (for instance, methoxystyrene, 4-methoxy-3-methylstyrene and dimethoxystyrene), halogenostyrene (for instance, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene and 4-fluoro-3-trifluoromethylstyrene);

crotonates such as alkyl crotonate (for instance, butyl crotonate, hexyl crotonate and glycerin monocrotonate); dialkyl itaconates such as dimethyl itaconate, diethyl itaconate and dibutyl itaconate); dialkyl maleates and fumarates such as dimethyl maleate and dibutyl fumarate; and (meth)acrylonitrile.

Among these compounds having polymerizable unsaturated bonds, preferably used are, for instance, (meth)acrylates, (meth)acrylamides, (meth)acrylonitrile and (meth)acrylic acid, with polymeric compounds comprising structural units represented by the following general formula (V) being particularly preferred because of good compatibility with the novolak resins and an ability of enhancing the printing durability of the resulting lithographic printing plate:

$$-[CH_2-C(R^6)(CO_2-(CH_2CH_2O)_nR^7)]- \qquad (V)$$

(wherein $R^6$ is a hydrogen atom or a methyl group; $R^7$ represents a hydrogen atom or a substituted or unsubstituted $C_1$-$C_{12}$ alkyl, $C_6$-$C_{12}$ cycloalkyl, $C_6$-$C_{12}$ aryl or $C_7$-$C_{14}$ aralkyl group, with a hydrogen atom or a methyl, ethyl, propyl, butyl or phenyl group being particularly preferred; and n is an integer of not less than 1 and not more than 20).

These copolymers of at least one compound having a polymerizable unsaturated bond with at least one compound having a sulfonamido group and a polymerizable unsaturated bond may be in the form of block, random or graft copolymers.

The content of the sulfonamido group-containing structural units represented by Formulas (I) and/or (II) is preferably not less than 5 mole% and more preferably 10 to 90 mole% on the basis of the total structural units of the copolymer. In addition, the content of the structural units represented by Formula (V) is preferably not less than 5 mole% and more preferably 10 to 40 mole% on the basis of the total structural units present in the copolymer.

As solvents used in the synthesis of these polymeric compounds, there may be used, for instance, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, dimethylsulfoxide, toluene, ethyl acetate, methyl lactate and ethyl lactate. These solvents may be used alone or in any combination. Moreover, water may optionally be added to these solvents.

The molecular weight of the polymeric compound used in the invention is preferably not less than 2,000 in terms of the weight-average molecular weight and not less than 1,000 in terms of the number-average molecular weight. More preferably, the weight-average molecular weight thereof ranges from 5,000 to 300,000 and the number-acverage molecular weight thereof ranges from 2,000 to 250,000. The polydispersity index (weight-average molecular weight/number-average molecular weight) of the polymeric compound is preferably not less than 1 and more preferably 1.1 to 10.

The polymeric compound used in the invention may comprise unreacted monomer components. In this case, the content of the monomers in the polymeric compound is desirably not more than 5% by weight on the basis of the total weight of the compound.

These polymeric compounds may be used alone or in combination. The amount of these polymeric compounds to be incorporated into the light-sensitive composition of the invention in general ranges from about 5 to 90% by weight and preferably about 5 to 85% by weight on the basis of the total weight of the composition.

On the other hand, the positive-working light-sensitive compounds used in the present invention include, for instance, o-naphthoquinonediazide compounds.

o-Naphthoquinonediazide compounds preferably used in the present invention are, for instance, esters of 1,2-diazonaphthoquinone-5-sulfonic acid chloride or 1,2-diazonaphthoquinone-4-sulfonic acid chloride with pyrogallol/acetone resins as disclosed in J.P. KOKOKU No. Sho 43-28403. Other preferred o-quinonediazide compounds are, for instance, esters of 1,2-diazonaphthoquinone-5-sulfonic acid chloride or 1,2-diazonaphthoquinone-4-sulfonic acid chloride with phenol/formaldehyde resins as disclosed in U.S. Patent Nos. 3,046,120 and 3,188,210 and esters of 1,2-diazonaphthoquinone-4-sulfonic acid chloride with phenol/formaldehyde resins as disclosed in J.P. KOKAI Nos. Hei 2-96163, Hei 2-96165 and Hei 2-96761. Other useful o-naphthoquinonediazide compounds are also known and disclosed in a large number of patents such as J.P. KOKAI Nos. Sho 47-5303, Sho 48-63802, Sho 48-63803, Sho 48-96575, Sho 49-38701 and Sho 48-13354, J.P. KOKOKU Nos. Sho 37-18015, Sho 41-11222, Sho 45-9610 and Sho 49-17481, U.S. Patent Nos. 2,797,213, 3,454,400, 3,544,323, 3,573,917, 3,674,495 and 3,785,825, U.K. Patent Nos. 1,227,602, 1,251,345, 1,267,005, 1,329,888 and 1,330,932 and German Patent No. 854,890.

Furthermore, preferably used are also include compounds obtained by reacting polyhydroxy compounds having molecular weights of not more than 1,000 with 1,2-diazonaphthoquinone-5-sulfonic acid chloride or 1,2-diazonaphthoquinone-4-sulfonic acid chloride. Specific examples of such compounds are disclosed in, for instance, J.P. KOKAI Nos. Sho 51-139402, Sho 58-150948, Sho 58-203434, Sho 59-165053, Sho 60-121445, Sho 60-134235, Sho 60-163043, Sho 61-118744, Sho 62-10645, Sho 62-10646, Sho 62-153950 and Sho 62-178562; Japanese Patent Application Serial (hereinafter referred to as "J.P.A.") No. Sho 62-233292; and U.S. Patent Nos. 3,102,809, 3,126,281, 3,130,047, 3,148,983, 3,184,310, 3,188,210 and 4,639,406.

In the synthesis of these o-naphthoquinonediazide compounds, the 1,2-diazonaphthoquinone sulfonic acid chloride is reacted with the polyhydroxy compound in an amount ranging from 0.2 to 1.2 eq. and preferably 0.3 to 1.0 eq. per unit equivalent of the hydroxyl group of the polyhydroxy compound. The 1,2-diazonaphthoquinone sulfonic acid chloride may be 1,2-diazonaphthoquinone-5-sulfonic acid chloride or 1,2-diazonaphthoquinone-4-sulfonic acid chloride.

Positive-working light-sensitive compounds other than o-naphthoquinonediazide compounds may likewise be used in the present invention and include, for instance, o-nitrocarbinol ester group-containing polymeric compounds as disclosed in J.P. KOKOKU No. Sho 56-2696.

Moreover, systems comprising combinations of compounds capable of generating acids through irradiation with light rays and compounds carrying groups: -C-O-C or -C-O-Si capable of being decomposed through the action of acids may also be used in the light-sensitive composition of the invention.

Specific examples thereof include combinations of photolytically acid-generating compounds with acetal or O,N-acetal compounds (J.P. KOKAI No. Sho 48-89003); orthoester or amidoacetal compounds (J.P. KOKAI No. Sho 51-120714); polymers carrying acetal or ketal groups in the main chains (J.P. KOKAI No. Sho 53-133429); enol ether compounds (J.P. KOKAI No. Sho 55-12995); N-acylimino carbon compounds (J.P. KOKAI No. Sho 55-126236); polymers carrying orthoester groups in the main chains (J.P. KOKAI No. Sho 56-17345); silyl ester compounds (J.P. KOKAI No. Sho 60-10247); and silyl ether compounds (J.P. KOKAI Nos. Sho 60-37549 and 60-121446).

The amount of these positive-working light-sensitive compounds (inclusive of the foregoing combinations) in general ranges from 10 to 50% by weight and preferably 15 to 40% by weight on the basis of the total weight of the light-sensitive composition according to the present invention.

In the light-sensitive composition of the present invention, the polymeric compounds having sulfonamido groups may preferably be used in combination with known alkali-soluble polymeric compounds such as phenol/formaldehyde resin; cresol/formaldehyde resins such as m-cresol/formaldehyde resin, p-cresol/formaldehyde resin, m-/p-mixed cresol/formaldehyde resin and mixed phenol/ (m-, p- or m-/p-mixed) cresol/formaldehyde resin; phenol-modified xylene resin, polyhydroxystyrene and/or polyhalogenated hydroxystyrene, with the combination thereof with cresol/formaldehyde resin being particularly preferred. The molecular weight of these alkali-soluble polymeric compounds preferably ranges from 500 to 20,000 in terms of the weight-average molecular weight and 200 to 60,000 in terms of the number-average molecular weight.

The amount of these alkali-soluble polymeric compounds is not more than 70% in general and more preferably 30 to 65% by weight on the basis of the total weight of the light-sensitive composition.

Further, it is preferred for the improvement of the ink-receptivity of images to simultaneously use condensates of phenol carrying alkyl group having 3 to 8 carbon atoms as substituents with formaldehyde such as t-butyl phenol/formaldehyde resin and octylphenol/formaldehyde resin as disclosed in U.S. Patent No. 4,123,279.

The light-sensitive composition of the present invention may preferably comprise cyclic acid anhydrides, phenols and/or organic acids in order to, enhance the sensitivity of the resulting light-sensitive composition.

Examples of cyclic acid anhydrides include phthalic anhydride, tetrahydrophthalic anhydride, hexahydrophthalic anhydride, 3,6-endoxy-$\Delta^4$-tetrahydrophthalic anhydride, maleic anhydride, chloromaleic anhydride, $\alpha$-phenylmaleic anhydride, succinic anhydride and pyromellitic anhydride.

Examples of phenols are bisphenol A, p-nitrophenol, p-ethoxyphenol, 2,3,4-trihydroxybenzophenone, 4-hydroxybenzophenone, 2,4,4'-trihydroxybenzophenone, 4,4',4''-trihydroxy-triphenylmethane and 4,4',3'',4''-tetrahydroxy-3,5,3',5'-tetramethyltriphenylmethane.

Examples of organic acids are sulfonic acids, sulfinic acids, alkylsulfuric acids, phosphonic acids, phosphinic acids, phosphoric acid esters and carboxylic acids as disclosed in J.P. KOKAI Nos. Sho 60-88942 and Hei 2-96755. Specific examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluylic acid, 3,4-dimethoxybenzoic acid, phthalic acid, terephthalic acid, 1,4-cyclohexene-2,2-dicarboxylic acid, erucic acid, lauric acid, n-undecanoic acid and ascorbic acid.

The foregoing cyclic acid anhydrides, phenols and/or organic acids are incorporated into the light-sensitive composition in an amount preferably ranging from 0.05 to 15% by weight and more preferably 0.1 to 5% by weight on the basis of the total weight of the composition.

The light-sensitive composition of the invention may further comprise nonionc surfactants such as those disclosed in J.P. KOKAI No. Sho 62-251740 and J.P.A. No. Hei 2-181248; amphoteric surface active agents as disclosed in J.P. KOKAI No. Sho 59-121044 and J.P.A. No. Hei 2-115992 in order to obtain a wider latitude of development.

Specific examples of these surfactants include polyoxyethylene polyoxypropylene block copolymers, sorbitan tristearate, sorbitan monopalmitate, sorbitan trioleate, stearic acid monoglyceride, polyoxyethylene sorbitan monooleate and polyoxyethylene nonylphenyl ether for nonionic surfactants; and alkyl di-(aminoethyl)glycine, alkyl polyaminoethyl glycine hydrochloride, Amorgen K (trade name of N-tetradecyl-N,N-betaine type surfactants available from Dai-ichi Kogyo Seiyaku Co., Ltd.), 2-alkyl-N-carboxyethyl-N-hydroxyethyl imidazolinium betaine and Lebon (trade name of alkylimidazoline type surfactants available from Sanyo Chemical Industries, Ltd.), with polyoxyethylene polyoxypropylene block copolymers being particularly preferred.

The foregoing nonionic and amphoteric surface active agents may be used alone or in combination and can be incoporated into the light-sensitive composition of the invention in an amount preferably ranging from 0.05 to 15% by weight and more preferably 0.1 to 5% by weight on the basis of the total weight of the composition.

The light-sensitive composition may further comprise a dye and/or another filler as an agent or composition for obtaining a visible image immediately after imagewise exposure to light or an agent for coloring an image.

Typical examples of the agent or composition for obtaining a visible image immediately after imagewise exposure to light are combinations of light-sensitive compounds capable of generating acids through exposure to light with organic dyes capable of forming salts. Specific examples thereof are combinations of o-naphthoquinonediazido-4-sulfonic acid halogenides with salt-forming organic dyes as disclosed in J.P. KOKAI Nos. Sho 50-36209 and Sho 53-8128; and combinations of trihalomethyl compounds with salt-forming oganic dyes as disclosed in J.P. KOKAI Nos. Sho 53-36223, Sho 54-74728, Sho 60-3626, Sho 61-143748, Sho 61-151644 and Sho 63-58440.

The trihalomethyl compounds comprise oxadiazole compounds and triazine compound, both of which are excellent in stability with time and can provide clear printed out images. However, the presence thereof causes the problem of, in particular, colors remaining after development in case of presensitized plates for use in making lithographic printing plates (hereinafter referred to as "PS plates") which make use of an aluminum substrate provided thereon with an oxidized layer of not less than 1.0 g/m$^2$ The concept of the present invention can effectively be applied to, in particular, the light-sensitive composition comprising these compounds and permits the preparation of lithographic printing plates substantially free of the remaining color.

Dyes other than the foregoing salt-forming organic dyes may likewise be used in the invention as agents for coloring images. Dyes (including the salt-forming organic dyes) preferably used in the invention are, for instance, oil-soluble dyes and basic dyes. Specific examples thereof include Oil Yellow #101, Oil Yellow #130, Oil Pink #312, Oil Green BG, Oil Blue BOS, Oil Blue #603, Oil Black BY, Oil Black BS, Oil Black T-505 (all of these dyes are available from Orient Chemical Industries, Co., Ltd.), Victoria Pure Blue, Crystal Violet, (CI 42555), Ethyl Violet (CI 42600), Methyl Violet (CI 42535), Rhodamine B (CI 45170B), Malachite Green (CI 42000) and Methylene Blue (CI 52015). In addition, dyes disclosed in J.P. KOKAI No. Sho 62-293247 are particularly preferred.

The light-sensitive composition of the invention is dissolved in a solvent which can dissolve the foregoing components and then applied onto the surface of a substrate. Examples of such solvents usable herein include ethylene dichloride, cyclohexanone, methyl ethyl ketone, ethylene glycol monomethyl ether, ethylene glycol monoethyl ether, 2-methoxyethyl acetate, 1-methoxy-2-propanol, 1-methoxy-2-propyl acetate, toluene, ethyl acetate, methyl lactate, ethyl lactate, dimethylsulfoxide, dimethylacetamide, dimethylformamide, water, N-methylpyrrolidone, tetrahydrofurfuryl alcohol, acetone, diacetone alcohol, methanol, ethanol, isopropanol and diethylene glycol dimethyl ether. These solvents may be used alone or in combination. The concentration of the foregoing components (solid content) in the solution ranges from 2 to 50% by weight. The amount of the light-sensitive composition to be applied varies depending on applications and, for instance, preferably ranges from 0.5 to 3.0 g/m$^2$ (solid content) for PS plates. The smaller the coated amount, the higher the sensitivity of the resulting light-sensitive film, but the lower the physical properties of the film.

The light-sensitive composition of the invention may preferably comprise a surfactant such as a fluorine atom-containing surfactant as disclosed in J.P. KOKAI No. Sho 62-170950 to improve the coating properties thereof. The amount thereof to be incorporated into the composition preferably ranges from 0.01 to 1% by weight and more preferably 0.05 to 0.5% by weight on the basis of the total weight of the composition.

When the light-sensitive composition of the invention is used for preparing a PS plate, an aluminum plate is preferably used as a substrate. The term "aluminum plate" herein used includes pure aluminum plates and aluminum alloy plates. Various kinds of aluminum alloys may be used in the invention and examples thereof include alloys of aluminum with metals such as silicon, copper, manganese, magnesium, chromium, zinc, lead, bismuth and nickel. These alloys may comprise negligible amounts of impurities in addition to certain amounts of iron and titanium.

The aluminum plate is optionally surface-treated. For instance, it is preferably subjected to surface-treatments such as graining, a treatment by immersing it into an aqueous solution of, for instance, sodium silicate, potassium fluorozirconate or phosphoric acid salts and/or anodization. Preferred aluminum substrates further include, for instance, those grained and then immersed in an aqueous sodium silicate solution as disclosed in U.S. Patent No. 2,714,066; and those anodized and then immersed in an aqueous solution of alkali metal silicate as disclosed in U.S. Patent No. 3,181,461. The anodization is, for instance, performed by passing an electric current through the aluminum plate serving as an anode in an electrolyte selected from the group consisting of aqueous solutions or non-aqueous solutions of inorganic acids such as phosphoric acid, chromic acid, sulfuric acid and boric acid, and organic acids such as oxalic acid and sulfamic acid and mixed solutions thereof.

It is also effective to use silicate electrodeposition technique as disclosed in U.S. Patent No. 3,658,662.

These hydrophilization treatments are carried out not only for the hydrophilization of the surface of the substrate but also for the prevention of any detrimental reaction with the light-sensitive composition subsequently applied thereto and for improving the adhesion to the light-sensitive layer.

The aluminum plates may be pre-treated to remove rolling oils adhered to the surface thereof and to expose clean surface thereof prior to the graining. A solvent such as trichlene or a surfactant has been used for the removal of rolling oils, while an alkali etching agent such as sodium hydroxide or potassium hydroxide has widely been used for exposing the clean surface of the aluminum substrate.

Effective surface-graining methods include mechanical, chemical and electrochemical ones. Examples of mechanical graining methods are ball graining, blast graining and brush graining which comprises rubbing the surface with a nylon brush in the presence of an aqueous dispersion or slurry of an abrasive such as pumice stone, examples of suitable chemical graining methods include those comprising immersing an aluminum plate in an aqueous saturated solution of an aluminum salt of a mineral acid as disclosed in J.P. KOKAI No. Sho 54-31187 and preferred electrochemical graining methods include those comprising alternating current-electrolysis performed in an acidic electrolyte such as hydrochloric acid, nitric acid or mixture thereof. Among these surface-roughening treatments, preferred are those disclosed in J.P. KOKAI No. Sho 55-137993 which comprise combinations of mechanical and electrochemical surface-roughening treatments. This is because, these methods permit the strong adhesion of ink-receptive images to the substrate.

The foregoing surface-graining treatment is preferably carried out to such an extent that the central line averaged surface roughness (Ha) of the aluminum plate treated reaches 0.3 to 1.0 $\mu$.

The aluminum plate thus grained is optionally washed with water and chemically etched. Etching solutions used are in general selected from auqeous solution of bases or acids capable of dissolving aluminum. In this respect, however, these etching solutions must be selected in such a manner that they never form, on the etched surface, a film originated from the components of the solutions other than aluminum. Examples of preferred etching agents are bases such as sodium hydroxide, potassium hydroxide, trisodium phosphate, disodium phosphate, tripotassium phosphate and dipotassium phosphate; and acids such as sulfuric acid, persulfuric acid, phosphoric acid, hydrochloric acid and salts thereof, but the salts thereof with metals having ionization tendency lower than that of aluminum such as zinc, chromium, cobalt, nickel and copper are not preferred because of the formation of undesired films on the etched surface.

The etching treatment is most preferably carried out in such a manner that the rate of dissolution of aluminum or an alloy thereof used ranges from 0.3 to 40 g per unit immersion time (one minute) at the concentration of each etching agent used and the established etching temperature. However, the present invention is not restricted to such an etching treatment.

The etching treatment can be carried out by immersing an aluminum plate in the foregoing etching solution or by applying an etching solution onto the surface of an aluminum plate and is performed to such an extent that the amount of aluminum removed through the etching reaches 0.5 to 10 g/m$^2$.

Preferred etching solutions are those of bases because of high etching rates. In this respect, the etching with an alkali solution accompanies the formation of smut and, therefore, the aluminum plate thus treated should be desmutted. The desmutting can be performed using an acid such as nitric acid, sulfuric acid, phosphoric acid, chromic acid, hydrofluoric acid and borofluoric acid.

The aluminum plate thus etched is optionally washed with water and subjected to anodization. The anodization may be performed by any known method conventionally used in this field. More specifically, a direct or alternating current is passed through the aluminum plate in an electrolyte selected from aqueous or non-aqueous solutions comprising at least one member selected from sulfuric acid, phosphoric acid, chromic acid, oxalic acid, sulfamic acid and benzenesulfonic acid to thus form an anodized layer on the surface of the aluminum substrate.

The conditions for the anodization vary depending on the kinds of electrolytes used, but are in general an electrolyte concentration ranging from 1 to 80% by weight; an anodization temperature ranging from 5 to 70 °C; a current density of 0.5 to 60 A/dm$^2$; an electric voltage of 1 to 100 V; and an electrolysis time of 30 seconds to 50 minutes.

Among these anodization treatments, preferred are a method for anodizing at a high current density in a sulfuric acid solution as disclosed in U.K. Patent No. 1,412,768; a method for anodization in a dilute sulfuric acid solution as disclosed in U.S. Patent No. 4,211,619; and a method in which a phosphoric acid solution is used as an electrolytic bath as disclosed in U.S. Patent No. 3,511,661.

The aluminum plate thus surface-roughened and anodized may, if necessary, be further hydrophilized. Examples of preferred such hydrophilization treatments are methods in which the aluminum plate is treated with an aqueous solution of an alkali metal silicate such as sodium silicate (see, for instance, U.S. Patent Nos. 2,714,066 and 3,181,461), a potassium fluorozirconate solution (see J.P. KOKOKU No. Sho 36-22063) and a polyvinylsulfonic acid solution (see U.S. Patent No. 4,153,461).

An underlying coating layer of a water-soluble compound may be applied onto the aluminum plate thus surface-roughened, then anodized and optionally hydrophilized. Examples of such water-soluble compounds are combinations of water-soluble metal salts and hydrophilic celluloses (for instance, a combination of zinc chloride with carboxymethyl cellulose and a combination of magnesium chloride with hydroxyethyl cellulose) as disclosed in J.P. KOKOKU No. Sho 57-16349; polyacrylamides as disclosed in U.S. Patent No. 3,511,661; polyvinylphosphonic acid as disclosed in J.P. KOKOKU No. Sho 46-35685; amino acids and salts thereof (for instance, alkali metal salts such as sodium and potassium salts, ammonium salts, hydrochlorides, oxalates, acetates and phosphates) as disclosed in J.P. KOKAI No. Sho 60-149491; amines having hydroxyl groups and salts thereof (for instance, hydrochlorides, oxalates and phosphates) as disclosed in J.P. KOKAI No. Sho 60-232998; compounds having amino groups and phosphonate residues and salts thereof as disclosed in J.P. KOKAI No. Sho 63-165183; compounds each having (a) an amino group and (b) a phosphonate, phosphinate or phosphate residue as disclosed in J.P.A. No. Hei 2-59592; and aliphatic or aromatic phosphonic or phosphinic acids or salts thereof as disclosed in J.P.A. No. Hei 3-10604, with the

EP 0 544 264 A1

compounds disclosed in J.P.A. Nos. 2-59592 and Hei 3-10604 being particularly preferred. The amount of the underlying coating layer of such a water-soluble compound preferably ranges from 1 to 80 mg/m$^2$ (in terms of the solid content).

The surface of the light-sensitive layer thus applied is preferably matted in order to reduce the time required for the evacuation during contact exposure to light in a vacuum printing frame and to prevent an image becoming indistinct. More specifically, the matting treatment can be carried out by methods comprising applying a mat layer as disclosed in J.P. KOKAI No. Sho 50-125805 and J.P. KOKOKU Nos. Sho 57-6582 and Sho 61-28986 and methods comprising heat-welding solid powder as disclosed in J.P. KOKOKU No. Sho 62-62337.

The developers for the light-sensitive composition of the present invention are preferably alkaline aqueous solutions substantially free of organic solvents. Specific examples thereof are aqueous solutions containing, for instance, sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium carbonate, sodium bicarbonate, potassium carbonate and/or potassium bicarbonate, and aqueous ammonia. The concentration of the aqueous solution ranges from 0.1 to 10% by weight and preferably 0.5 to 5% by weight.

Among these, preferred are, for instance, developers containing alkali silicates such as potassium silicate, lithium silicate and sodium silicate. This is because they hardly cause contamination during printing. In particularly preferred developers, the alkali silicate has a molar ratio: $[SiO_2]/[M]$ (wherein $[SiO_2]$ and $[M]$ represent the molar concentration of $SiO_2$ and the molar concentration of the sum of the alkali metal present) ranging from 0.5 to 2.5 and the content of $SiO_2$ ranges from 0.8 to 8% by weight. In addition, the developer may comprise a water-soluble salt of sulfurous acid such as sodium sulfite, potassium sulfite or magnesium sulfite; resorcin, methylresorcin, hydroquinone and/or thiosalicylic acid. These compounds may be incorporated into the developer in an amount ranging from 0.002 to 4% by weight and preferably 0.01 to 1% by weight.

The developer preferably comprises at least one surfactant selected from anionic and amphoteric surfactants disclosed in J.P. KOKAI Nos. Sho 50-51324 and Sho 59-84241 and nonionic surfactants disclosed in J.P. KOKAI Nos. Sho 59-75255, Sho 60-11246 and Sho 60-213943; or a polyelectrolyte disclosed in J.P. KOKAI Nos. Sho 55-95946 and Sho 50-142528 for improving the ability of wetting the light-sensitive composition and ensuring stable development (improvement of development latitude). These surfactants are added to the developer in an amount preferably ranging from 0.001 to 2% by weight, in particular 0.003 to 0.5% by weight. Moreover, the alkali metals in the alkali silicate comprise potassium in an amount of preferably not less than 20 mole%, more preferably not less than 90 mole% and most preferably 100 mole% on the basis of the total amount of the alkali metals. This limitation permits substantial reduction of the amount of insolubles formed in the developer during development.

The developer used in the invention may comprise a small amount of an organic solvent such as alcohol; a chelating agent as disclosed in J.P. KOKAI No. Sho 58-190952; and/or an antifoaming agent such as a metal salt or an organic silane compound disclosed in J.P. KOKOKU No. Hei 1-30139.

Light sources such as carbon arc lamps, mercury lamps, xenon lamps, tungsten lamps and metal halode lamps may be used for exposing the light-sensitive layer formed from the composition of the invention.

The PS plate obtained using the light-sensitive composition of the invention may of course be treated by the plate making methods disclosed in J.P. KOKAI Nos. Sho 54-8002, Sho 55-115045 and Sho 59-58431. More specifically, after development, the PS plate may be washed with water and then subjected to desensitization treatment; or desensitized without water-washing; or treated with an aqueous solution containing an acid; or treated with an aqueous solution containing an acid and then desensitized. Further, in the development of the PS plate of this kind, the alkali concentration in the developer is reduced due to the consumption thereof in proportion-to the amount of the PS plate treated or the consumption thereof due to carbon dioxide in the air during operation of an automatic developing machine over a long time. In this case, the processing ability of the developer may be recovered by supplementing a replenisher as disclosed in J.P. KOKAI No. Sho 54-62004. The supplementation of the replenisher is preferably performed according to the method disclosed in U.S. Patent No. 4,882,246. The foregoing plate-making process is preferably carried out in an automatic developing machine as disclosed in J.P. KOKAI Nos. Hei 2-7054 and Hei 2-32357.

Moreover, when the PS plate obtained using the light-sensitive composition of the invention is imagewise exposed to light, developed, washed with water or rinsed and then treated to eliminate unnecessary portions of images, the elimination is preferably performed with an elimination solution as disclosed in J.P. KOKOKU No. Hei 2-13293. Further, a desensitizing gum is optionally applied to the plate

10

as the final process of the plate-making method. Examples of such desensitizing gums are those disclosed in J.P. KOKOKU Nos. Sho 62-16834, Sho 62-25118 and Sho 63-52600 and J.P. KOKAI Nos. Sho 62-7595, Sho 62-11693 and Sho 62-83194.

In addition, the PS plate obtained using the light-sensitive composition of the invention is subjected to burning after imagewise exposure to light, development, water-washing or rinsing, optional elimination treatment and then water-washing, the plate is preferably treated with a counter-etching or affinitizing solution such as those disclosed in J.P. KOKOKU Nos. Sho 61-2518 and Sho 55-28062 and J.P. KOKAI Nos. Sho 62-31859 and Sho 61-159655, prior to the burning treatment.

The light-sensitive composition of the present invention has good solubility in a coating solvent and is excellent in coating properties and the imagewise exposed area thereof has good developability with respect to an aqueous alkaline developer after coating, drying, imagewise exposing to light. Further, the resulting relief images have excellent wear resistance, good adhesion to the substrate, excellent resistance to defects such as those formed through scratching and/or rubbing and can provide a large number of copies when used as a lithographic printing plate.

The light-sensitive composition of the present invention will hereinafter be explained in more detail with reference to the following Preparation Examples and non-limitative working Examples, but the present invention is not limited to these specific Examples.

Preparation Example 1

To a 1 ℓ volume three-necked flask equipped with a stirrer, a condenser and a dropping funnel, there were added 170.2 g (1.0 mole) of p-aminobenzenesulfonamide and 700 ml of tetrahydrofuran and the mixture was stirred with cooling in an ice-bath. Acrylic acid chloride (45.3 g; 0.5 mole) was dropwise added to this mixture through the dropping funnel over about one hour. After completion of the dropwise addition, the ice-bath was removed, the mixture was stirred at room temperature for 30 minutes and further stirred with heating at 60°C in an oil bath over one hour. After completion of the reaction, the reaction mixture was poured into 3 ℓ of water, followed by stirring for 30 minutes and filtration to give N-(p-aminosulfonylphenyl)-acrylamide as a white solid. The white solid was purified through recrystallization from a water-acetone mixed solvent (yield 32.5 g).

A mixture of 9.04 g (0.040 mole) of the resulting N-(p-aminosulfonylphenyl)acrylamide, 7.93 g (0.080 mole) of methyl methacrylate and 50 ml of N,N-dimethylformamide was introduced into a 200 ml volume three-necked flask equipped with a stirrer and a condenser and stirred under heating at 64 °C in a hot water bath. To the mixture, there was added 0.246 g of α,α'-azobisisobutyronitrile and the resulting mixture was stirred for 5 hours in a nitrogen gas stream while maintaining the temperature at 64 °C. After completion of the reaction, the reaction mixture was poured into 2 ℓ of water, followed by stirring for 30 minutes, filtration and drying to give 16 g of a white solid. The weight-average molecular weight of the polymer obtained was determined by gel permeation chromatography (molecular weight standard: polystyrene) and was found to be 49,000 (Polymeric Compound (a) of the present invention).

Preparation Example 2

To a 500 ml volume 3-necked flask equipped with a stirrer, a condenser and a dropping funnel, there were added 25.9 g (0.36 mole) of acrylic acid, 39.1 g (0.36 mole) of ethyl chloroformate and 200 ml of acetonitrile and the mixture was stirred with cooling in an ice-bath. To the mixture, there was dropwise added 36.4 g (0.36 mole) of triethylamine through the dropping funnel over about one hour. After completion of the dropwise addition, the ice-bath was removed, followed by stirring the mixture at room temperature for 30 minutes and then dipping the flask in an oil bath.

To the reaction mixture, there was added 51.7 g (0.30 mole) of p-aminobenzenesulfonamide and the mixture was stirred for one hour with warming to 70°C in the oil bath. After completion of the reaction, the mixture was poured into 1 ℓ of water with stirring and stirred for additional 30 minutes. The resulting solid was collected through filtration, dispersed in 500 ml of water to give a slurry, followed by filtration and drying to give N-(p-aminosulfonylphenyl)acrylamide as a white solid (yield 37.2 g).

To a 200 ml volume 3-necked flask equipped with a stirrer, a condenser and a dropping funnel, there were then added 6.10 g (0.027 mole) of the resulting N-(p-aminosulfonylphenyl) acrylamide, 2.98 g (0.021 mole) of butyl methacrylate, 1.56 g (0.012 mole) of 2-hydroxyethyl methacrylate and 20 g of N,N-dimethylacetamide followed by stirring with heating to 65 °C in a hot water bath. To this mixture, there was added 0.15 g of V-65 (available from Wako Pure Chemical Industries, Ltd.) followed by stirring for 30 minutes in a nitrogen gas stream while maintaining the temperature thereof at 65 °C. To the reaction

11

mixture, there were further dropwise added a mixture comprising 6.10 g of N-(p-aminosulfonylphenyl)-acrylamide, 2.98 g of butyl methacrylate, 1.56 g of 2-hydroxyethyl methacrylate, 20 g of N,N-dimethylacetamide and 0.15 g of V-65 through the dropping funnel over one hour. After completion of the dropwise addition, the reaction mixture was further stirred at 65 °C for 2 hours. After completion of the reaction, 40 g of methanol was added to the mixture to cool the same, followed by addition of the mixture to 2 ℓ of water with stirring, stirring for additional 30 minutes, filtration and drying to give 15 g of a white solid. The weight-average molecular weight of the polymer obtained was determined by gel permeation chromatography (molecular weight standard: polystyrene) and was found to be 63,000 (Polymeric Compound (b) of the present invention).

Preparation Example 3

To a 2 ℓ volume 3-necked flask equipped with a stirrer, a condenser and a dropping funnel, there were added 170.2 g (1.0 mole) of p-aminobenzenesulfonamide and 1 ℓ of acetone followed by stirring at room temperature. To the mixture, there was added 101 g (1.0 mole) of triethylamine, followed by dropwise addition of 127.5 g (1.0 mole) of 2-chloropropionic acid chloride over about one hour through the dropping funnel. After completion of the dropwise addition, the stirring of the mixture was continued at room temperature for 2 hours.

After 2 hours, the reaction solution was cooled to 0°C and then 242.4 g (2.4 moles) of triethylamine was dropwise added to the solution through the dropping funnel while maintaining the temperature of the solution to not more than 10 °C.

The temperature of the reaction solution was brought back to room temperature and then the solution was stirred for 4 hours. The reaction solution was added to an aqueous solution of acetic acid (prepared by adding 150 g of glacial acetic acid to 10 ℓ of water ) under stirring to give N-(p-a minosulfonylphenyl)-acrylamide as a white solid. The white solid was washed with 3 ℓ of distilled water and then dried under reduced pressure (yield 120 g).

Then, 6.51 g (0.029 mole) of N-(p-aminosulfonylphenyl) acrylamide, 2.46 g (0.019 mole) of butyl acrylate, 2.26 g (0.012 mole) of diethylene glycol monomethyl ether methacrylate and 20 g of N,N-dimethylacetamide were introduced into a 200 ml volume 3-necked flask equipped with a stirrer, a condenser and a dropping funnel and stirred under heating to 70°C in a hot water bath. To the mixture, there was added 0.15 g of V-601 (available from Wako Pure Chemical Industries, Ltd.) followed by stirring for 30 minutes in a nitrogen gas stream while maintaining the temperature to 70 °C. To the mixture, there were further dropwise added a mixture comprising 6.51 g of N-(p-aminosulfonylphenyl)acrylamide, 2.46 g of butyl acrylate, 2.26 g of diethylene glycol monomethyl ether methacrylate, 20 g of N,N-dimethylacetamide and 0.15 g of V-601 over one hour through the dropping funnel. After completion of the dropwise addition, the mixture was further stirred at 70°C for 2 hours. After completion of the reaction, 40 g of methanol was added to the mixture to cool the same, followed by pouring the mixture into 2 ℓ of water with stirring, stirring for additional 30 minutes, filtration and drying to give 13 g of a white solid. The weight-average molecular weight of the polymer obtained was determined by gel permeation chromatography (molecular weight standard: polystyrene) and was found to be 86,000 (Polymeric Compound (c) of the present invention).

Preparation Examples 4 to 5

The same procedures used in Preparation Example 1, 2 or 3 were repeated to give polymeric compounds (d) to (e). The weight-average molecular weights (polystyrene standard) of these polymeric compounds are listed in the following Table 1.

## Table 1

| Polymeric Compound of the Invention | Structural Units | | | Molar Ratio | Weight-average Molecular Weight | Residual Monomer |
|---|---|---|---|---|---|---|
| (a) | $-(CH_2-CH)-$, $CONH-C_6H_4-SO_2NH_2$ | $-(CH_2-C(CH_3))-$, $CO_2CH_3$ | | 34 : 66 | 90300 | 0.8 % |
| (b) | $-(CH_2-CH)-$, $CONH-C_6H_4-SO_2NH_2$ | $-(CH_2-C(CH_3))-$, $CO_2CH_2CH_2CH_2CH_3$ | $-(CH_2-C(CH_3))-$, $CO_2CH_2CH_2OH$ | 45 : 35 : 20 | 63000 | 0.5 % |
| (c) | $-(CH_2-CH)-$, $CONH-C_6H_4-SO_2NH_2$ | $-(CH_2-CH)-$, $CO_2CH_2CH_2CH_2CH_3$ | $-(CH_2-C(CH_3))-$, $CO_2(CH_2CH_2O)_2CH_3$ | 48 : 32 : 20 | 86000 | 0.2 % |
| (d) | $-(CH_2-CH)-$, $CONH-C_6H_4$ (with $SO_2NH_2$) | $-(CH_2-C(CH_3))-$, $CO_2CH_2CH_2CH_3$ | $-(CH_2-CH)-$, $CO_2(CH_2CH_2O)_4CH_3$ | 42 : 36 : 22 | 41000 | 0.4 % |
| (e) | $-(CH_2-CH)-$, $CONH-C_6H_4-SO_2NH-C_6H_5$ | $-(CH_2-C(CH_3))-$, $CO_2CH_2CH_2-O-P(=O)(OH)-OH$ | $-(CH_2-C(CH_3))-$, $CO_2CH_3$ | 25 : 27 : 48 | 27000 | 1.2 % |

Methacrylamide or methacrylate monomer corresponding to Formula (III) or (IV) was synthesized by a method similar to that used in Preparation Example 1 or 2 and then polymerized to obtain Comparative Polymers (a') to (e') (see Table 2) against Polymeric Compounds (a) to (e).

13

Table 2

| Polymeric Compound for Comparison | Structural Units | Molar Ratio | Weight-average Molecular Weight | Residual Monomer |
|---|---|---|---|---|
| (a') | (structural units) | 34 : 66 | 51000 | 8 % |
| (b') | (structural units) | 45 : 35 : 20 | 32000 | 17 % |
| (c') | (structural units) | 48 : 32 : 20 | 51000 | 13 % |
| (d') | (structural units) | 42 : 36 : 22 | 28000 | 14 % |
| (e') | (structural units) | 25 : 27 : 48 | 16000 | 19 % |

## Examples [A]-1 to [A]-5, [B]-1 to [B]-5 and Comparative Examples [A']-1 to [A']-5, [B']-1 to [B']-5 and [C]

An aluminum plate having a thickness of 0.30 mm was surface-grained using a nylon brush and an aqueous suspension of pumice stone and then sufficiently washed with water. The plate was then etched by immersing in a 10% sodium hydroxide solution at 70°C for 60 seconds followed by washing with running water, neutralization and washing with a 20% $HNO_3$ solution and water-washing. The plate was then subjected to electrolytic surface-roughening treatment using a sinusoidal alternating waved current at in $V_A$

14

of 12.7 V such that the quantity of electricity at the anode time was 160 coulomb/dm$^2$ in a 1% aqueous nitric acid solution. At this stage, the surface roughness thereof was determined and was found to be 0.6μ (in terms of Ra unit). Subsequently, the plate was immersed in a 30% $H_2SO_4$ aqueoussolution at 55°C for 2 minutes to desmut, followed by anodization at a current density of 2 A/dm$^2$ in a 20% $H_2SO_4$ aqueous solution so that the thickness of the anodized layer reached 2.7 g/m$^2$ to give Substrate (I). An underlying coating solution having the following composition was applied onto the surface of Substrate (I) thus treated and dried at 80°C for 30 seconds to thus prepare Substrate (II). The coated amount weighed after drying was 30 mg/m$^2$.

| Underlying Coating Solution | |
| --- | --- |
| Component | Amount (g) |
| phenylphosphonic acid | 0.15 |
| methanol | 90 |
| pure water | 10 |

Thereafter, five kinds of light-sensitive solutions [A]-1 to [A]-5 were prepared using 5 kinds of Polymeric Compounds of the present invention in the following light-sensitive solution [A]. Separately, 5 kinds of light-sensitive solutions [A']-1 to [A']-5 were likewise prepared using Comparative Polymers (a') to (e') in the following light-sensitive solution [A']. These light-sensitive solutions each was applied onto Substrate (II) and dried at 100°C for 2 minutes to give each corresponding PS plate [A]-1 to [A]-5, [A']-1 to [A']-5. The coated amount of each light-sensitive solution was 2.5 g/m$^2$ (weighed after drying). Polymeric compounds used in the light-sensitive solutions [A]-1 to [A]-5 and [A']-1 to [A']-5 are listed in the following Table 3.

| Light-Sensitive Solution [A] or [A'] | |
| --- | --- |
| Component | Amount (g) |
| ester compound of naphthoquinone-1,2-diazido-5-sulfonylchloride with pyrogallol/acetone resin (disclosed in Example 1 of U.S. Patent No. 3,635,709) | 0.45 |
| Polymeric Compound or Comparative Polymer | 1.10 |
| 2-(p-methoxyphenyl)-4,6-bis(trichloromethyl)-s-triazine | 0.02 |
| tetrahydrophthalic anhydride | 0.05 |
| Victoria Pure Blue BOH (available from Hodogaya Chemical Co., Ltd.) | 0.01 |
| Megafack F-177 (fluorine atom-containing surfactant available from Dainippon Ink and Chemicals, Inc.) | 0.006 |
| Pluronic F-108 (polyoxyethylene polyoxypropylene block copolymer available from Asahi Denka Kogyo K.K.) | 0.02 |
| methyl ethyl ketone | 10 |
| 1-methoxy-2-propanol | 10 |

Then light-sensitive solutions [B]-1 to [B]-5 and [B']-1 to [B']-5 were prepared using Polymeric Compounds of the present invention and Comparative Polymers (a') to (e') in the following light-sensitive solution [B]. These light-sensitive solutions were likewise applied to aluminum substrates under the same conditions used in the application of the light-sensitive solution [A] to give PS plates [B]-1 to [B]-5 and [B']-1 to [B']-5. The coated amount of each light-sensitive solution was 2.5 g/m$^2$ (weighed after drying).

| Light-sensitive Solution [B] or [B'] | |
|---|---|
| Component | Amount (g) |
| ester compound of naphthoquinone-1,2-diazido-5-sulfonylchloride with pyrogallol/acetone resin (disclosed in Example 1 of U.S. Patent No. 3,635,709) | 0.45 |
| Polymeric Compound or Comparative Polymer | 0.5 |
| cresol/formaldehyde novolak resin (m-/p- ratio: 6:4; weight-average molecular weight 3,000; number-average molecular weight 1,100) | 0.6 |
| 2-(p-methoxyphenyl)-4,6-bis(trichloromethyl)-s-triazine | 0.02 |
| tetrahydrophthalic anhydride | 0.05 |
| Victoria Pure Blue BOH (available from Hodogaya Chemical Co., Ltd.) | 0.02 |
| Megafack F-177 (fluorine atom-containing surfactant available from Dainippon Ink and Chemicals, Inc.) | 0.006 |
| Pluronic F-108 (available from Asahi Denka Kogyo K.K.) | 0.02 |
| methyl ethyl ketone | 10 |
| 1-methoxy-2-propanol | 10 |

Moreover, a light-sensitive solution [C] having the following composition was applied onto an aluminum substrate in the same manner used in the application of the light-sensitive solutions [A] and [B] to give a PS plate [C]. The coated amount of the light-sensitive solution was 2.5 g/m$^2$ (weighed after drying).

| Light-Sensitive Solution [C] | |
|---|---|
| Component | Amount (g) |
| ester compound of naphthoquinone-1,2-diazido-5-sulfonylchloride with pyrogallol/acetone resin (disclosed in Example 1 of U.S. Patent No. 3,635,709) | 0.45 |
| cresol/formaldehyde novolak resin (m-/p- ratio: 6:4; weight-average molecular weight 3,000; number-average molecular weight 1,100) | 1.10 |
| 2-(p-methoxyphenyl)-4,6-bis(trichloromethyl)-s-triazine | 0.02 |
| tetrahydrophthalic anhydride | 0.05 |
| tris(p-diethylaminophenyl)methane 6-hydroxy-2-naphthalenesulfonate | 0.02 |
| Megafack F-177 | 0.006 |
| Pluronic F-108 (available from Asahi Denka Kogyo K.K.) | 0.02 |
| methyl ethyl ketone | 10 |
| 1-methoxy-2-propanol | 10 |

Each light-sensitive layer of these PS plates [A]-1 to [A]-5, [A']-1 to [A']-5, [B]-1 to [B]-5, [B']-1 to [B']-5 and [C] was brought into close contact with a positive original transparency carrying line drawings and half-tone dot images and the assembly was imagewise exposed to light from a 30A carbon arc lamp at a distance of 70 cm.

The imagewise exposed PS plates [A]-1 to [A]-5, [A']-1 to [A']-5, [B]-1 to [B]-5, [B']-1 to [B']-5 and [C] were developed by dipping them in an aqueous solution of DP-4 (trade name: available from Fuji Photo Film Co., Ltd.) diluted 8 times at 25 °C for 60 seconds.

The resulting lithographic printing plates [A]-1 to [A]-5, [A']-1 to [A']-5, [B]-1 to [B]-5, [B']-1 to [B']-5 and [C] each was fitted to a KOR Type printing press (available from Heidelberg Co., Ltd.) and printing operations were carried out using wood-free paper and a commercially available ink. At this stage, the printing durability, tolerance for appropriate developing conditions and resistance to defects of these lithographic printing plates were evaluated. The results obtained are summarized in the following Table 3.

Each PS plate was exposed to light through a gray scale having a density difference of 0.15 (available from Fuji Photo Film Co., Ltd.) and developed by dipping in an aqueous solution of DP-4 diluted 6 times at 25 °C for 30 seconds or by dipping in an aqueous solution of DP-4 diluted 8 times at 25 °C for 30 seconds (i.e., under the standard conditions for development). Thus, the tolerance for appropriate developing conditions (T.A.D.C.) was evaluated in terms of the difference between the numbers of solid steps of the gray scale observed in the foregoing two developing processes. Moreover, the resistance to defects was evaluated in terms of the amount of defects formed when the image-carrying face of each imagewise exposed PS plate was intensely rubbed with gloves of cloth.

16

Table 3

| PS Plate | Polymeric Compound Used | Printing Durability (Number of Copies) | T.A.D.C. | Resistance to Defects |
|---|---|---|---|---|
| [A]-1 | (a) | 60,000 | 2.5 | A |
| [A]-2 | (b) | 65,000 | 2.5 | A |
| [A]-3 | (c) | 65,000 | 2.5 | A |
| [A]-4 | (d) | 70,000 | 2.5 | A |
| [A]-5 | (e) | 50,000 | 2.5 | A |
| [A']-1 | (a') | 50,000 | 4.0 | A |
| [A']-2 | (b') | 55,000 | 4.0 | A |
| [A']-3 | (c') | 55,000 | 4.0 | A |
| [A']-4 | (d') | 55,000 | 4.0 | A |
| [A']-5 | (e') | 45,000 | 4.0 | A |
| [B]-1 | (a) | 60,000 | 2.0 | A |
| [B]-2 | (b) | 75,000 | 2.0 | A |
| [B]-3 | (c) | 75,000 | 2.0 | A |
| [B]-4 | (d) | 75,000 | 2.0 | A |
| [B]-5 | (e) | 55,000 | 2.0 | A |
| [B']-1 | (a') | 40,000 | 3.0 | A |
| [B']-2 | (b') | 40,000 | 3.0 | A |
| [B']-3 | (c') | 45,000 | 3.0 | A |
| [B']-4 | (d') | 40,000 | 3.0 | A |
| [B']-5 | (e') | 35,000 | 3.0 | A |
| [C] | cresol/formaldehyde novolak resin | 40,000 | 2.0 | B |

Evaluation Criteria of Resistance to Defects:
A: good; B: insufficient.

The data listed in Table 3 clearly indicate that the lithographic printing plates [A]-1 to [A]-5 and [B]-1 to [B]-5 obtained using Polymeric Compounds (a) to (e) exhibit printing durability and tolerance for appropriate developing conditions substantially superior to those of the lithographic printing plates [A']-1 to [A']-5 and [B']-1 to [B']-5 prepared using Comparative Polymers (a') to (e') and the lithographic printing plate [C].

Examples [D]-1 to [D]-5 and Comparative Examples [D']-1 to [D']-5

Five kinds of light-sensitive solutions [D]-1 to [D]-5 obtained using Polymeric Compounds in the following light-sensitive solution [D] each was applied onto the surface of Substrate (II) prepared under the same conditions used in Example [A] and dried at 100 °C for 2 minutes to give each corresponding PS plate [D]-1 to [D]-5.

Comparative PS plates [D']-1 to [D']-5 were prepared using 5 kinds of light-sensitive solutions [D']-1 to [D']-5 prepared from the following light-sensitive solution [D'] while using different Comparative Polymers, in the same manner used above.

| Light-Sensitive Solution [D] or [D'] | |
|---|---|
| Component | Amount (g) |
| ester compound of naphthoquinone-1,2-diazido-5-sulfonylchloride with m-cresol/formaldehyde novolak resin | 0.45 |
| Polymeric Compound or Comparative Polymer | 0.5 |
| cresol/formaldehyde novolak resin (m-/p- ratio: 6:4; weight-average molecular weight 3,000; number-average molecular weight 1,100) | 0.6 |
| 2-(p-methoxyphenyl)-4,6-bis(trichloromethyl)-s-triazine | 0.02 |
| tetrahydrophthalic anhydride | 0.05 |
| Victoria Pure Blue BOH (available from Hodogaya Chemical Co., Ltd.) | 0.02 |
| Megafack F-177 | 0.006 |
| Pluronic F-88 (available from Asahi Denka Kogyo K.K.) | 0.02 |
| methyl ethyl ketone | 10 |
| 1-methoxy-2-propanol | 10 |

A PS plate [E] was separately prepared using the light-sensitive solution [D] wherein 1.1 g of cresol/formaldehyde novolak resin (m-/p- ratio: 6:4; weight-average molecular weight 3,000; number-average molecular weight 1,100) was substituted for Polymeric Compound of the invention. In these PS plates [D]-1 to [D]-5, [D']-1 to [D']-5 and [E], the coated amounts of these light-sensitive solutions were 2.5 g/m$^2$ (weighed after drying).

The PS plates [D]-1 to [D]-5, [D']-1 to [D']-5 and [E] were subjected to the same quality evaluation tests used in Examples [A] and [B] and Comparative Examples [A'], [B'] and [C]. The results thus obtained are summarized in the following Table 4.

Table 4

| PS Plate | Polymeric Compound Used | Printing Durability (Number of Copies) | T.A.D.C. | Resistance to Defects |
|---|---|---|---|---|
| [D]-1 | (a) | 60,000 | 2.0 | A |
| [D]-2 | (b) | 70,000 | 2.0 | A |
| [D]-3 | (c) | 75,000 | 2.0 | A |
| [D]-4 | (d) | 70,000 | 2.0 | A |
| [D]-5 | (e) | 60,000 | 2.0 | A |
| [D']-1 | (a') | 40,000 | 3.0 | A |
| [D']-2 | (b') | 35,000 | 3.0 | A |
| [D']-3 | (c') | 45,000 | 3.0 | A |
| [D']-4 | (d') | 45,000 | 3.0 | A |
| [D']-5 | (e') | 40,000 | 3.0 | A |
| [E] | cresol/formaldehyde novolak resin | 40,000 | 2.0 | B |

The data listed in Table 4 clearly indicate that the lithographic printing plates [D]-1 to [D]-5 obtained using Polymeric Compounds (a) to (e) of the present invention exhibit printing durability and tolerance for appropriate developing conditions substantially superior to those of the comparative lithographic printing plates [D']-1 to [D']-5 prepared using Comparative Polymers (a') to (e') or the lithographic printing plate [E].

Examples [F]-1 to [F]-5 and Comparative Examples [F']-1 to [F']-5

Five kinds of light-sensitive solutions [F]-1 to [F]-5 obtained using Polymeric Compounds in the following light-sensitive solution [F] each was applied onto the surface of Substrate (II) prepared under the same conditions used in Example [A] and dried at 100 °C for 2 minutes to give each corresponding PS plate [F]-1 to [F]-5.

Comparative PS plates [F']-I to [F']-5 were separately prepared using 5 kinds of light-sensitive solutions [F']-1 to [F']-5 obtained from the following light-sensitive solution [F'] while using different Comparative Polymers, in the same manner used above. In these PS plates [F]-1 to [F]-5 and [F']-1 to [F']-5, the coated amounts of these light-sensitive solutions were 2.5 g/m$^2$ (weighed after drying).

18

| Light-Sensitive Solution [F] or [F'] | |
| --- | --- |
| Component | Amount (g) |
| ester compound of naphthoquinone-1,2-diazido-5-sulfonylchloride with 2,3,4-trihydroxybenzophenone (degree of esterification: 90 mole%) | 0.45 |
| Polymeric Compound or Comparative Polymer | 0.77 |
| cresol/formaldehyde novolak resin (m-/p- ratio: 6:4; weight-average molecular weight 3,000; number-average molecular weight 1,100) | 0.33 |
| 2-(p-methoxyphenyl)-4,6-bis(trichloromethyl)-s-triazine | 0.22 |
| naphthoquinone-1,2-diazido-4-sulfonylchloride | 0.01 |
| tetrahydrophthalic anhydride | 0.05 |
| Victoria Pure Blue BOH (dye available from Hodogaya Chemical Co., Ltd.) | 0.015 |
| Megafack F-177 (fluorine atom-containing surfactant, available from Dainippon Ink and Chemicals, Inc.) | 0.004 |
| Pluronic F-68 (available from Asahi Denka Kogyo K.K.) | 0.02 |
| dimethoxyformamide | 4 |
| 1-methoxy-2-propanol | 9 |
| methyl ethyl ketone | 7 |

A PS plate [G] was separately prepared using the light-sensitive solution [F] wherein 1.1 g of cresol/formaldehyde resin (m-/p- ratio: 6:4; weight-average molecular weight 3,000; number-average molecular weight 1,100) was substituted for Polymeric Compound of the invention. The coated amount of the solution was 2.5 g/m$^2$ (weighed after drying).

The PS plates [F]-1 to [F]-5, [F']-1 to [F']-5 and [G] were subjected to the same quality evaluation tests used in Examples [A] and Comparative Examples [A']. The results thus obtained are summarized in the following Table 5.

Table 5

| PS Plate | Polymeric Compound Used | Printing Durability (Number of Copies) | T.A.D.C. | Resistance to Defects |
| --- | --- | --- | --- | --- |
| [F]-1 | (a) | 60,000 | 2.0 | A |
| [F]-2 | (b) | 70,000 | 2.0 | A |
| [F]-3 | (c) | 70,000 | 2.0 | A |
| [F]-4 | (d) | 65,000 | 2.0 | A |
| [F]-5 | (e) | 40,000 | 2.0 | A |
| [F']-1 | (a') | 30,000 | 3.0 | A |
| [F']-2 | (b') | 35,000 | 3.0 | A |
| [F']-3 | (c') | 35,000 | 3.0 | A |
| [F']-4 | (d') | 30,000 | 3.0 | A |
| [F']-5 | (e') | 30,000 | 3.0 | A |
| [G] | cresol/ formaldehyde novolak resin | 30,000 | 2.0 | B |

The data listed in Table 5 clearly indicate that the lithographic printing plates [F]-1 to [F]-5 exhibit printing durability and tolerance for appropriate developing conditions substantially superior to those of the comparative lithographic printing plates [F']-1 to [F']-5 or the lithographic printing plate [G].

## Claims

1. A light-sensitive composition comprising at least one water-insoluble and alkaline aqueous solution-soluble polymeric compound comprising structural units represented by the following general formulas (I) and/or (II) and a positive-working light-sensitive compound:

-[CH$_2$-CH(CO-X$^1$-R$^1$-SO$_2$NH-R$^2$)]-  (I)

-[CH$_2$-CH(CO-X$^2$-R$^3$-NHSO$_2$-R$^4$)]-  (II)

wherein $X^1$ and $X^2$ each represents -O- or $-NR^5$ -; $R^1$ and $R^3$ each represents a substituted or unsubstituted alkylene, cycloalkylene, arylene or aralkylene group; $R^2$ represents a hydrogen atom or a substituted or unsubstituted alkyl, cycloalkyl, aryl or aralkyl group; $R^4$ represents a substituted or unsubstituted alkyl, cycloalkyl, aryl or aralkyl group; and $R^5$ represents a hydrogen atom or a substituted or unsubstituted alkyl, cycloalkyl, aryl or aralkyl group.

2. The light-sensitive composition of claim 1 wherein the polymeric compound is a homopolymer or copolymer of monomers represented by the following general formula (III) or (IV) or a copolymer of at least one monomer selected from those represented by the general formulas (III) and (IV) with at least one compound having at least one polymerizable unsaturated bond and free of sulfonamido group:

$$CH_2 = CH(CO-X^1-R^1-SO_2NH-R^2) \quad (III)$$

$$CH_2 = CH(CO-X^2-R^3-NHSO_2-R^4) \quad (IV)$$

wherein $X^1$ and $X^2$ each represents -O- or $-NR^5$ -; $R^1$ and $R^3$ each represents a substituted or unsubstituted $C_1$-$C_{12}$ alkylene, $C_6$-$C_{12}$ cycloalkylene, $C_6$-$C_{12}$ arylene or $C_7$-$C_{14}$ aralkylene group; $R^2$ represents a hydrogen atom or a substituted or unsubstituted $C_1$-$C_{12}$ alkyl, $C_6$-$C_{12}$ cycloalkyl, $C_6$-$C_{12}$ aryl or $C_7$-$C_{14}$ aralkyl group; $R^4$ represents a substituted or unsubstituted $C_1$-$C_{12}$ alkyl, $C_6$-$C_{12}$ cycloalkyl, $C_6$-$C_{12}$ aryl or $C_7$-$C_{14}$ aralkyl group; and $R^5$ represents a hydrogen atom or a substituted or unsubstituted $C_1$-$C_{12}$ alkyl, $C_6$-$C_{12}$ cycloalkyl, $C_6$-$C_{12}$ aryl or $C_7$-$C_{14}$ aralkyl group.

3. The light-sensitive composition of claim 2 wherein, in the general formulas (III) and (IV), $R^1$ and $R^3$ each represents a $C_2$-$C_6$ alkylene group, a $C_6$-$C_{12}$ cycloalkylene group or a substituted or unsubstituted phenylene or naphthylene group; $R^2$ represents a hydrogen atom or a $C_1$-$C_6$ alkyl group, a $C_6$-$C_{12}$ cycloalkyl group or a substituted or unsubstituted phenyl or naphthyl group; $R^4$ represents a $C_1$-$C_6$ alkyl group, a $C_6$-$C_{12}$ cycloalkyl group or a substituted or unsubstituted phenyl or naphthyl group; and $R^5$ represents a hydrogen atom.

4. The light-sensitive composition of claim 1 wherein the polymeric compound is at least one member selected from the group consisting of those comprising structural units represented by the following general formula (V):

$$-[CH_2-C(R^6)(CO_2-(CH_2CH_2O)_nR^7)]- \quad (V)$$

wherein $R^6$ is a hydrogen atom or a methyl group; $R^7$ represents a hydrogen atom or a substituted or unsubstituted $C_1$-$C_{12}$ alkyl, $C_1$-$C_{12}$ cycloalkyl, $C_6$-$C_{12}$ aryl or $C_7$-$C_{14}$ aralkyl group; and n is an integer of not less than 1 and not more than 20).

5. The light-sensitive composition of claim 4 wherein the content of the structural units represented by the general formula (V) ranges from 10 to 40 mole% on the basis of the total structural units present in the copolymer.

6. The light-sensitive composition of claim 1 wherein the content of the sulfonamido group-containing structural units represented by Formula (I) or (II) ranges from 10 to 90 mole% on the basis of the total structural units present in the polymeric compound.

7. The light-sensitive composition of claim 1 wherein the polymeric compound has a weight-average molecular weight ranging from 5,000 to 300,000 and a number-average molecular weight ranging from 2,000 to 250,000 and the polydispersity index thereof ranges from 1.1 to 10.

8. The light-sensitive composition of claim 1 wherein the amount of the polymeric compound ranges from about 5 to 85% by weight on the basis of the total weight of the light-sensitive composition.

9. The light-sensitive composition of claim 1 wherein the content of the positive-working light-sensitive compound in the composition ranges from 15 to 40% by weight on the basis of the total weight of the composition.

10. The light-sensitive composition of claim 1 wherein it further comprises at least one additive selected from the group consisting of alkali-soluble polymeric compounds having a weight-average molecular weight ranging from 500 to 20,000 and a number-average molecular weight ranging from 200 to 60,000; condensates of phenols carrying alkyl groups having 3 to 8 carbon atoms with formaldehyde; cyclic acid anhydrides, phenols, organic acids; nonionic and amphoteric surfactants; agents or compositions for obtaining visible images immediately after imagewise exposure and agents for coloring images; and fluorine atom-containing surfactants.

European Patent
Office

**EUROPEAN SEARCH REPORT**

Application Number

EP    92 12 0111

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 330 239 (FUJI PHOTO FILM CO LTD) * the whole document * | 1-10 | G03F7/023 |

TECHNICAL FIELDS
SEARCHED (Int. Cl.5 )

G03F

The present search report has been drawn up for all claims

| Place of search | Date of completion of the search | Examiner |
|---|---|---|
| THE HAGUE | 12 MARCH 1993 | Martine LUDI |